# EUROPÄISCHE PATENTSCHRIFT

(11) **EP 0 294 592 B1**
(45) Veröffentlichungstag und Bekanntmachung des Hinweises auf die Patenterteilung: **04.08.1993**
(21) Anmeldenummer: 88107232.6
(22) Anmeldetag: 05.05.1988
(51) Int. Cl.: G01R 1/073

(54) **Anschlussausführung in der Leiterplattenprüftechnik**
Contact device for the technique of testing circuit boards
Dispositif de contact dans la technique pour tester des circuits imprimés

(30) Priorität: 09.06.1987 DE 3719205
(43) Veröffentlichungstag der Anmeldung: 14.12.1988
(73) Patentinhaber: Siemens Nixdorf Informationssysteme Aktiengesellschaft, 33102 Paderborn (DE)
(72) Erfinder: Zdenek, Urban, Dipl.-Ing., D-8000 München 70 (DE)
(74) Vertreter: Fuchs, Franz-Josef, Dr.-Ing.

(56) Entgegenhaltungen:
- DE-A- 3 240 415
- US-A- 4 177 425
- IBM TECHNICAL DISCLOSURE BULLETIN, Band 13, Nr. 1, Juni 1970, Seiten 169-170, New York, US; R. BOVE: "Kelvin probe"
- IBM TECHNICAL DISCLOSURE BULLETIN, Band 19, Nr. 12, Mai 1977, Seiten 4686-4687, New York, US; K.F. GREENE et al.: "Flexible electrical probe and method of manufacture"

## Beschreibung

Die Erfindung bezieht sich auf einen Prüfadapter, insbesondere für die Leiterplattenprüfung, mit
- in einem Kontaktnadelträger in mehreren Reihen angeordneten Kontaktnadeln und
- einer Mehrlagenverdrahtung als mechanisches Gegenlager zur Aufnahme des Kontaktdrucks und als elektrische Verbindung zwischen den Kontaktnadeln und einem Prüfautomaten.

Ein derartiger Prüfadapter ist aus der DE-A-3 240 415 bekannt.

Leiterplatten werden vor dem Bestücken einer elektrischen Verdrahtungsprüfung unterzogen. Dies geschieht mit Hilfe eines Verdrahtungsprüfautomaten, mit dem die zu prüfende Leiterplatte über einen Nadeladapter verbunden ist. Durch diese Prüfung können Leitungsunterbrechungen und -schlüsse zwischen den Leiterbahnen erkannt werden (siehe Petermann: Leiterplatten, 1975).

Federnde Prüfkontakte sind universell einsetzbar in Prüfautomaten und Prüfadaptern für unbestückte und bestückte Leiterplatten sowie für Verdrahtungsfelder in Löt- oder Crimp-Technik. Der Prüfkontakt ist zum Beispiel ein Stahlstift mit Edelmetalloberfläche, der auf einer Feder aufgesetzt und mit dieser in einem Federgehäuse untergebracht ist. Mit diesen Prüfkontakten werden die Prüflinge auf Durchgang und Isolation geprüft. Die Verbindung der Prüfkontakte mit den Durchschaltebaugruppen erfolgt mittels Anschlußbuchsen und Litzen (gewrapt, gelötet, gecrimpt). Solche Prüfadapter sind für Prüfraster > 0,7 mm einsetzbar.

Bei dem in der DE-A-3 240 415 dargestellten zweiteiligen Adapter, der aus einem Anschlußteil und einem Kontaktnadelträger aufgebaut ist, erfolgt die Verbindung mittels Kontaktstiften oder stirnseitig unter 90° angeschliffener Kontaktdrähte. Diese Drähte sind auf einer Seite im Prüfraster eingegossen. Auf der anderen Seite sind sie frei beweglich und können mit einem Stecker verlötet werden. Diese Adapter sind für Prüfraster < 0,3 mm dieser Zeit nicht realisiert.

In der genannten DE-A-3 240 415 ist aber bereits auch darauf hingewiesen, daß statt dem Anschlußteil (Druckplatte) eine Mehrlagenverdrahtung vorgesehen sein kann, die ein mechanisches Gegenlager zur Vermittelung des Kontaktdruckes ist. Durch das Ersetzen der diskreten Verdrahtung durch eine Mehrlagenverdrahtung ergibt sich ein übersichtlicherer und wartungsfreundlicherer Adapteraufbau. Die Verbindung unter 90° mittels einer konventionell hergestellten 2-lagigen Leiterplatte, welche auf einer Außenseite im Prüfraster angeordnete Kontaktpads < φ 0,4 mm aufweist, welche mittels dieser Leiterplatte zu den Steckern der Durchschaltbaugruppe hin verbunden sind, ist aber in ihrer Verwendung sehr stark eingeschränkt. Mit dieser Anordnung können nämlich maximal nur zwei hintereinander angeordnete Nadelreihen verdrahtet werden.

Aus IBM Technical Disclosure Bulletin, Band 19, Nr. 12, Mai 1977, Seiten 4686-4687 ist ein Prüfadapter bekannt, der durch eine Leiterplatte mit zwei äußeren Verdrahtungslagen gebildet ist. In den beiden äußeren Verdrahtungslagen der Leiterplatte sind einzelne Leiter in Form von Leiterbahnen ausgebildet. Durch Entfernung eines stirnseitigen Bereichs der Leiterplatte ergibt sich ein Überstand der einzelnen Leiter, so daß die Testflächen eines Prüflings durch die überstehenden Leiter federnd kontaktiert werden können.

Der Erfindung liegt die Aufgabe zugrunde, einen hauptsächlich für Prüfraster kleiner als 0,7 mm geeigneten Prüfadapter zu schaffen, bei welchem die Kontaktnadeln in mehreren Reihen angeordnet werden können.

Die Aufgabe wird bei einem Prüfadapter der eingangs genannten Art erfindungsgemäß dadurch gelöst, daß
- jeder Reihe von Kontaktnadeln eine Verdrahtungsebene der Mehrlagenverdrahtung zugeordnet ist, daß
- die Mehrlagenverdrahtung mit den Leitern an der dem Kontaktnadelträger zugeordneten Seite unter einem Winkel 0° < α < 90° schräg angeschliffen ist und daß die schräg angeschliffenen Leiter der Mehrlagenverdrahtung in der Ebene des Anschliffs unmittelbar an die Kontaktnadeln herangeführt sind.

Gemäß einer vorteilhaften Ausgestaltung der Erfindung ist vorgesehen, daß die Mehrlagenverdrahtung mit Durchschaltebaugruppen des Prüfautomaten elektrisch verbunden ist und daß die Mehrlagenverdrahtung, die Durchschaltebaugruppen und der Kontaktnadelträger jeweils als austauschbare Einheit ausgebildet sind.

Die Erfindung zielt in ihrer Anwendung hauptsächlich auf Prüfraster < 0,7 mm ab, ist jedoch nach unten auch bei wesentlich engeren Prüfrastern anwendbar bis dann in der mechanischen Kontaktnadelführung eine Grenze gesetzt ist.

Der wesentliche Vorteil der Erfindung liegt darin begründet, daß sie es ermöglicht in dem gesamten Rasterbereich nicht nur zwei hintereinanderliegende Nadelreihen zu verdrahten, sondern die Anzahl der Nadelreihen entsprechend der Lagenzahl der der Erfindung zugrundeliegenden Leiterplatte auf zum Beispiel 28 oder mehr auszubauen.

Durch geeignete Wahl des Anschliffwinkels kann der Abstand der Anschlußflächen an den Abstand der Nadelreihen des Adapters angepaßt werden (x-Richtung). Der Abstand der Kontaktnadeln in y-Richtung ist durch das geätzte Leiterbild in der Mehrlagenleiterplatte (Anschlußflecke) vorgegeben (zum Beispiel bei 80 µm Leiterbreite und 50 µm Leiterabstand ergibt sich ein Kontaktnadelabstand von 130 µm).

Die Größe des Kontaktpads ist in x-Richtung durch die Höhe des geätzten Leiters und durch den Anschliffwinkel bestimmt. In y-Richtung entspricht sie der geätzten Leiterbreite (zum Beispiel 80 µm).

Die Lösung nach der Erfindung hat ferner den Vorteil, daß die benötigte, schräg angeschliffene Leiterplatte mittels der bekannten Verfahren für die Herstellung von Mehrlagenleiterplatten angefertigt werden kann.

Die Erfindung wird anhand der Figuren erläutert. Es zeigen:
- Figur 1: eine schematische Darstellung einer angeschliffenen Mehrlagenverdrahtung und
- Figur 2: eine Anordnung einer Mehrlagenverdrahtung schematisch in der Seitenansicht in einem Prüfadapter.

Die Mehrlagenverdrahtung umfaßt beispielsweise drei Verdrahtungsebenen 1, die mit einem Prepreg (Harz) 2 zu einer Leiterplatte 3 verpreßt sind. Mittels Durchkontaktierungen 4 sind die Leiterbahnen der Verdrahtungsebenen nach außen herausgeführt. Mit α ist der Schleifwinkel bezeichnet. Die von den Anschlußflecken 5 ausgehenden Pfeile zeigen schematisch den nicht dargestellten Nadelträger.

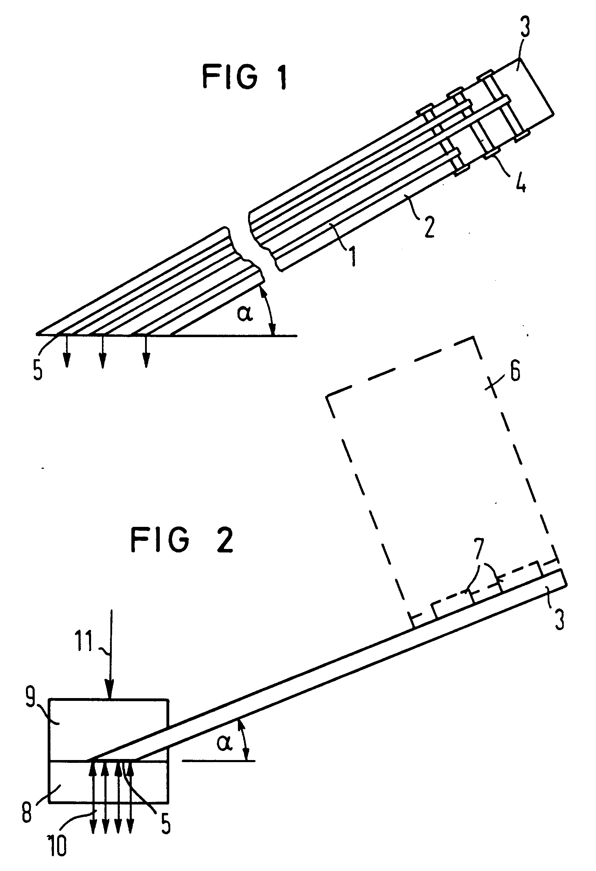

In der Figur 2 ist am rechten Rand eine Durchschaltebaugruppe 6 von mehreren möglichen Baugruppen gestrichelt dargestellt. Über Stecker 7 ist diese Baugruppe mit der Leiterplatte (Mehrlagenverdrahtung) 3 elektrisch verbunden. Diese oder mehrere Baugruppen 6 sind Teil eines Prüfautomaten.

Am linken Rand ist ein Kontaktnadelträger 8 in Verbindung mit einer mechanischen Halterung 9 angedeutet. Mit Pfeilen 10 sind Kontaktnadeln bezeichnet, die einen nicht dargestellten Prüfling kontaktieren. Der Pfeil 11 symbolisiert die ausgeübte Kontaktkraft. Die mechanische Anordnung 8, 9 ermöglicht die Kraft 11 axial an die Kontaktnadeln 10 zu bringen und die Halterung 9 auch beliebig massiv und bei Bedarf auch aus Metall (elektrisch leitend) auszuführen.

## Patentansprüche

1. Prüfadapter, vorzugsweise für die Leiterplattenprüfung, mit
- in einem Kontaktnadelträger (8) in mehreren Reihen angeordneten Kontaktnadeln (10) und
- einer Mehrlagenverdrahtung (3) als mechanisches Gegenlager zur Aufnahme des Kontaktdrucks und als elektrische Verbindung zwischen den Kontaktnadeln (10) und einem Prüfautomaten,
**dadurch gekennzeichnet,** daß
- jeder Reihe von Kontaktnadeln (8) eine Verdrahtungsebene (1) der Mehrlagenverdrahtung (3) zugeordnet ist, daß
- die Mehrlagenverdrahtung (3) mit den Leitern an der dem Kontaktnadelträger (8) zugeordneten Seite unter einem Winkel 0° < α < 90° schräg angeschliffen ist und daß
- die schräg angeschliffenen Leiter der Mehrlagenverdrahtung (3) in der Ebene des Anschliffs unmittelbar an die Kontaktnadeln (10) herangeführt sind.

2. Prüfadapter nach Anspruch 1,
**dadurch gekennzeichnet,**
daß die Mehrlagenverdrahtung (3) mit Durchschaltebaugruppen (6) des Prüfautomaten elektrisch verbunden ist und daß die Mehrlagenverdrahtung (3), die Durchschaltebaugruppen (6) und der Kontaktnadelträger (8) jeweils als austauschbare Einheit ausgebildet sind.

## Claims

1. Test adaptor, preferably for testing printed circuit boards, having
- contact needles (10) arranged in several rows in a contact needle carrier (8) and
- a multilayer wiring (3) as a mechanical counter-bearing for receiving the contact pressure and as an electrical connection between the contact needles (10) and an automatic test device,
characterised in that
- each row of contact needles (10) is assigned a wiring plane (1) of the multilayer wiring (3), in that
- the multilayer wiring (3) with the conductors on the side assigned to the contact needle carrier (8) is obliquely ground at an angle of 0° < α < 90° and in that
- the obliquely ground conductors of the multilayer wiring (3) are routed directly to the contact needles (10) in the plane of the ground portion.

2. Test adaptor according to Claim 1, characterised in that the multilayer wiring (3) is electrically connected to junction assemblies (6) of the automatic test device, and in that the multilayer wiring (3), the junction assemblies (6) and the contact needle carrier (8) are each constructed as a replaceable unit.

## Revendications

1. Adaptateur de contrôle, de préférence pour le contrôle de plaquettes à circuits imprimés, comportant
- des aiguilles de contact (10) disposées suivant plusieurs rangées dans un support (8) d'aiguilles de contact, et
- un câblage à plusieurs couches (3) formant support mécanique destiné à supporter la pression de contact et formant liaison électrique entre les aiguilles de contact (10) et un automate de contrôle,
caractérisé par le fait que
- à chaque série d'aiguilles de contact (8) est associé un plan de câblage (1) du câblage à couches multiples (3),
- le câblage à couches multiples (3) équipé des conducteurs situés sur le côté tourné vers le support (8) d'aiguilles de contact est biseauté en oblique sous un angle de 0° < α < 90°, et
- les conducteurs biseautés en oblique du câblage à couches multiples (3) sont appliqués directement contre les aiguilles de contact (10), dans le plan de biseautage.

2. Adaptateur de contrôle suivant la revendication 1, caractérisé par le fait que le câblage à couches multiples (3) est raccordé électriquement à des modules d'interconnexion (6) de l'automate de contrôle et que le câblage à plusieurs couches (3), les modules d'interconnexion (6) et le support (8) des aiguilles de contact sont agencés respectivement sous la forme d'une unité interchangeable.
